# EUROPEAN PATENT SPECIFICATION

(11) **EP 3 433 628 B1**
(45) Date of publication and mention of the grant of the patent: **22.01.2020**
(21) Application number: 17714551.3
(22) Date of filing: 24.03.2017
(51) Int. Cl.: G01R 31/36, G01R 31/367, G01R 31/396

(54) **AN ENERGY STORAGE DEVICE MONITORING TECHNIQUE**
ENERGIESPEICHERVORRICHTUNGSÜBERWACHUNGSTECHNIK
TECHNIQUE DE SURVEILLANCE DE DISPOSITIF DE STOCKAGE D'ÉNERGIE

(30) Priority: 24.03.2016 GB 201605060
(43) Date of publication of application: 30.01.2019
(73) Proprietor: Imperial College Innovations Limited, London SW7 2AZ (GB)
(72) Inventor: WU, Billy, London Greater London SW7 2AZ (GB); OFFER, Gregory, London Greater London SW7 2AZ (GB); VLADIMIR, Yufit, London Greater London SW7 2AZ (GB); MERLA, Yuri, London Greater London SW7 2AZ (GB)
(74) Representative: Howson, Richard Giles Bentham
(86) International application number: PCT/GB2017/050850
(87) International publication number: WO 2017/163089

(56) References cited:
- US-A1- 2011 148 424
- US-A1- 2012 105 069
- US-A1- 2012 188 086
- US-A1- 2013 135 110

## Description

### Field

The present disclosure relates to the monitoring of the condition of cells within an electrochemical storage device, such as a battery.

### Background

As portable devices are provided with additional functionality, and as electrical power is adopted in place of alternative power sources (such as in electric vehicles), battery performance is becoming a key limiting factor on device adoption. In order to provide users with a satisfactory experience, there is a desire not only to enhance fundamental battery life but also to ensure accurate information is provided in order to manage expectations and optimise battery use. To this end, battery management systems (BMS) are provided to allow indications of battery characteristics to device users. For example, the user of an electric vehicle may be provided with information regarding the expected range of the vehicle and the user of a mobile phone may be provided with an estimated percentage of battery life remaining.

To estimate the range of a vehicle, for example, it is desirable to have an understanding not only of the battery's state of charge (SOC) but also state of health (SOH). An accurate estimation of these properties is not trivial and requires more than mere knowledge of cell voltage.

Batteries degrade through various mechanisms over time and individual cells in a pack may age differently. This unequal degradation can lead to reduced overall pack performance and lifetime which means particular cells may need to be controlled or replaced accordingly. Moreover, the performance of the pack will be determined by the weakest cell. Hence a good diagnosis method capable of accurately identifying such cells with detailed state-of-health information is required.

Efforts have been made to develop techniques to monitor battery state-of-health. However, many such techniques are not suitable for practical implementation, requiring complex and expensive equipment such as in-situ nuclear magnetic resonance or x-ray computational tomography. Other techniques have proposed using entropy and enthalpy measurements at specific cell potentials where each potential was related to a particular electrode. For example, DuBarry et al (Cell degradation in commercial LiFePO4 cells with high-power and high-energy designs, J. Power Sources. 258 (2014) 408-419) proposed a mechanistic model to go with an incremental capacity analysis in which the model compares the dQ/dV peaks with its fresh cell equivalent to quantify cell state-of-health in terms of degradation modes such as loss of lithium inventory, loss of active materials and ohmic resistance increase. In this approach, each dQ/dV peak represents a combined phase of both positive and negative electrodes.

To avoid the requirement for a separate current measurement for each cell, differential thermal voltammetry (DTV) has been proposed introduced as a complimentary tool to slow-rate cyclic voltammetry (SRCV) and incremental capacity analysis. Examples of this approach can be found in "Differential thermal voltammetry for tracking of degradation in lithium-ion batteries" (Wu et al, J. Power Sources. 273 (2015) 495-501) and "Novel application of differential thermal voltammetry as an in-depth state of health diagnosis method for lithium-ion batteries" (Merla et al, J. Power Sources. 307 (2016) 308-319).

DTV only requires temperature and voltage measurements (i.e. no current measurement is required) and it is carried out by measuring the change in cell surface temperature during a constant current discharge. The DTV parameter, dT/dV is calculated by taking the differential of the temperature, dT/dt divided by the differential of the potential, dV/dt. Plotted against cell potential, the result gives as much information as a SRCV but with the addition of the entropic term.

Existing experiments for DTV have been carried out on individual cells under natural thermal boundary conditions. In reality, the cells would be connected into a pack with a thermal management system. Furthermore, existing approaches have been developed for constant current discharge which meant that the diagnosis required a dedicated discharge cycle in application. Additional art is found in US 2011/148424, US 2012/188086, US 2013/135110, and US 2012/105069.

There remains, therefore, a need to provide a technique for analysis of state of health of cells within a battery under realistic conditions. In particular, there is a desire to avoid cost and complexity in this analysis and also ensure that the analysis does not intrude on the desired operation of the battery.

### Summary

According to a first aspect of the disclosure, there is provided a method of monitoring the condition of one or more cells within an electrochemical energy storage device, the method comprising:
operating the electrochemical device at a current comprising a predefined time-varying component for a first period of time;
sensing voltage across each of the plurality of cells during the first time period;
sensing a measure of heat generation within each cell during the first time period;
calculating an estimate of the open circuit potential of the electrochemical storage device from the predefined time varying component of the current and the sensed voltage during the first time period;
calculating, for each cell, a function which relates a ratio of the time derivatives of the sensed measure of heat generation and voltage to the open circuit potential; and
determining a measure of the state of health of each cell based on the calculated function.

According to a second aspect of the disclosure, there is provided a system for monitoring the condition of one or more cells within an electrochemical energy storage device, the system comprising a device configured to:
operate the electrochemical device at a current comprising a predefined time-varying component for a first period of time;
sense voltage across each of the plurality of cells during the first time period;
sense a measure of heat generation within each cell during the first time period;
calculate an estimate of the open circuit potential of the electrochemical storage device from the predefined time varying component of the current and the sensed voltage during the first time period;
calculate, for each cell, a function which relates a ratio of the time derivatives of the sensed measure of heat generation and voltage to the open circuit potential; and
determine a measure of the state of health of each cell based on the calculated function.

The present disclosure provides a system and method which can accurately identify differences in state of health between cells within an electrochemical energy storage device, such as a battery. The electrochemical energy storage device may comprise a single cell or a plurality of cells. It has been shown that by estimating open circuit potential from the response to a defined time varying input current, the ratio of time derivatives of a measure of heat generation and voltage can offer insight into the condition of each cell. This is achieved without a requirement for direct current measurement within each cell, or other complex measurement systems.

The electrical energy storage device may be in the form of a battery. The electrical energy storage device may comprise a Faradaic, pseudo-Faradaic and/or non-Faradaic electrochemical storage device. For example the electrical energy storage device may be or comprise one more or all of a battery or batteries, capacitors, supercapacitors, hybrid battery-supercapacitors and other similar devices.

In some preferred embodiments, the measure of heat generation is a temperature measurement. Alternatively or additionally, the measure of heat generation is a heat flux measurement. Temperature measurement devices are widely available and can be relatively cheaply implemented. Heat flux measurement may provide a more accurate reflection of the true entropic state of the cell, particularly in temperature controlled conditions (e.g. where the battery is actively cooled) which may otherwise interfere with a pure temperature measurement.

In preferred embodiments, the step of operating the electrochemical device at a current comprises charging the electrochemical device. Alternatively, the step of operating the electrochemical device at a current may comprise discharging the electrochemical device. Where the operation comprises charging the device, it can be implemented into the controlled conditions already provided in many systems during charging, rather than having an impact on battery usage during often less controlled discharge.

In a preferred embodiment, the step of operating the electrochemical device at a current comprises applying an intermittent current profile. Alternatively, the step of operating the electrochemical device at a current comprises applying an oscillating current profile.

Preferably, the method further comprises, prior to calculating the ratio of time derivatives, smoothing values of the sensed measure of heat generation. In preferred embodiments, the step of smoothing comprises applying a moving average. In this manner outlying results within a set of measured values are not given undue weight in later calculations.

In preferred embodiments, the step of calculating an estimate of open circuit potential comprises fitting a rest profile of the sensed voltage to a power law model. Alternatively or additionally, the step of calculating an estimate of open circuit potential comprises applying a diffusion equation to the sensed voltage. These techniques have been shown to provide adequate estimates of the open circuit potential from limited data.

In preferred embodiments, the step of determining a measure of the state of health of each cell comprises analysing peaks within the calculated function. Peaks within the calculated function have been found to reflect the state of health of the cell. These thus represent a parameter that indicates changes in state of health which can be readily identified without burdensome complex analysis of the data distribution.

Preferably, the method further comprises calculating an operating range for each cell from the measure of the state of health for that cell. In this manner a parameter to ensure future operation is tailored to the current state of health so as to ensure optimum overall cell usage can be identified. The method may, for example, further comprise operating the electrochemical storage device such that each cell remains within its operating range.

It can also be appreciated that aspects of the disclosure can be implemented using computer program code. Indeed, according to a further aspect of the present disclosure, there is therefore provided a computer program product comprising computer executable instructions for carrying out the method of the first aspect. The computer program product may be a physical / tangible storage medium. For example, the storage medium may be a Read Only Memory (ROM) or other memory chip. Alternatively, it may be a disk such as a Digital Versatile Disk (DVD-ROM) or other data carrier. It could also be a signal such as an electronic signal over wires, an optical signal or a radio signal such as to a satellite or the like. The disclosure also extends to a processor running the software or code, e.g. a computer configured to carry out the method described above.

### Brief Description of the Figures

A preferred embodiment of the disclosure will now be described with reference to the accompanying drawings, in which
Figure 1 shows a system for monitoring cells within a battery pack;
Figure 2 shows the battery pack in more detail;
Figure 3 illustrates a process for monitoring the condition of cells within the battery pack;
Figures 4A and 4B illustrate estimated and actual OCV curves;
Figure 5 shows an OCV corrected DTV curve;
Figure 6 shows pack experimental results for 2C (40A) discharge;
Figure 7.shows peak fitting of differential thermal and heat flux voltammetry results for 2C constant current discharger;
Figure 8 shows a schematic of combined phase transitions in graphitic carbon negative electrode and NMC positive electrode;
Figure 9 shows pack experimental results for 2C (40A) charge; and
Figure 10 shows peak fitting of differential thermal and heat flux voltammetry results for 2C constant current charge.

### Detailed Description

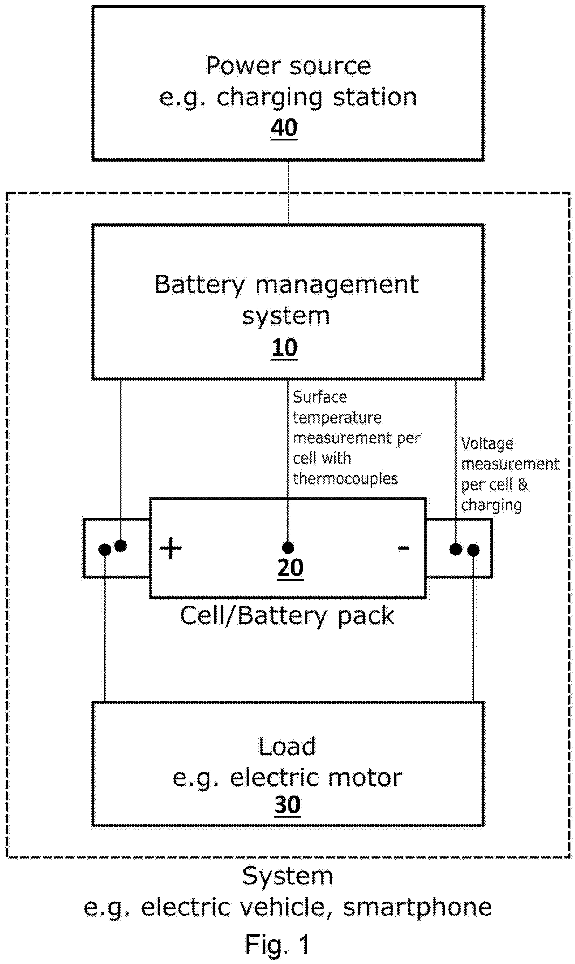

Referring to Figure 1, a system is shown comprising a battery management system 10, a battery pack 20 and a load 30 coupled to one another. An internal or external power source 40 may also be provided. The system may be integrated into a portable device or an electric vehicle, or any other context in which power is required. In alternative embodiments, the battery pack may be replaced by a single cell.

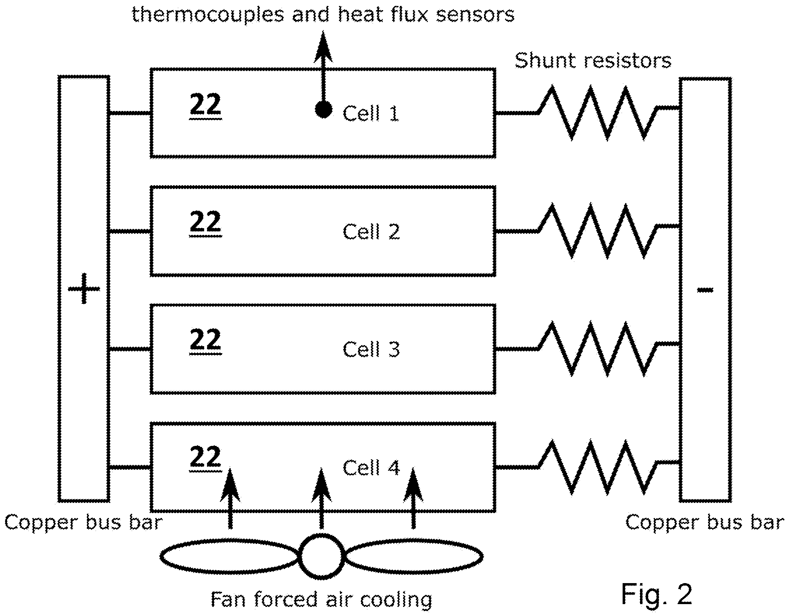

The battery pack 20 is shown in more detail in Figure 2. In this embodiment, the battery pack is made from four commercial 5Ah lithium-polymer pouch cells 22 connected in parallel. The cells are manufactured by Dow Kokam (model number SLPB11543140H5) and each cell consists of a carbon graphite negative electrode and a nickel-manganese-cobalt (Ni1/3Mn1/3Co1/3) positive electrode. Heat flux sensors with type K thermocouples (OMEGA HFS-4) were placed on the surface at the centre of the cell. The pack is prepared in a way to minimise differences in external resistance such as equal cable lengths, fastening torque (8kN) and cleaned contact surfaces.

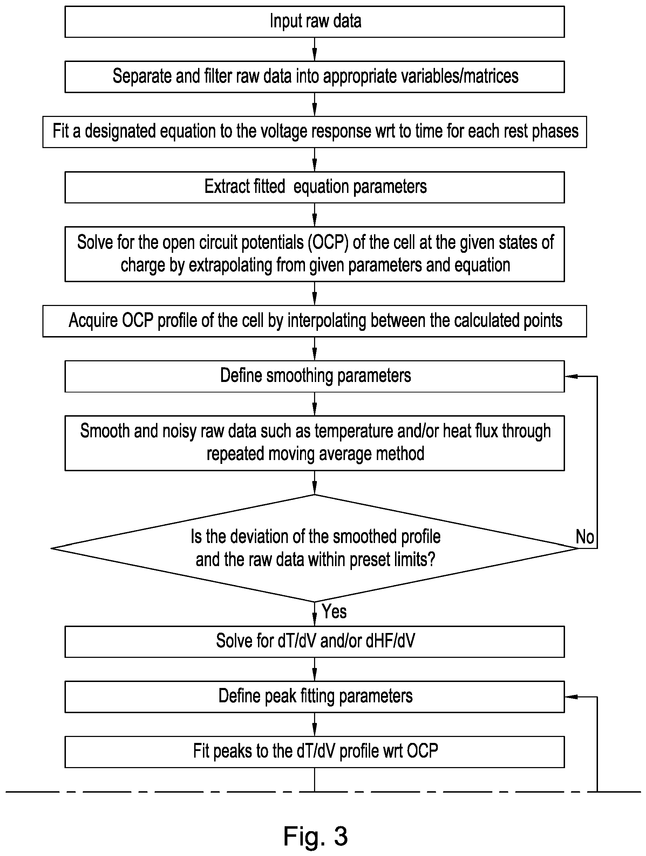

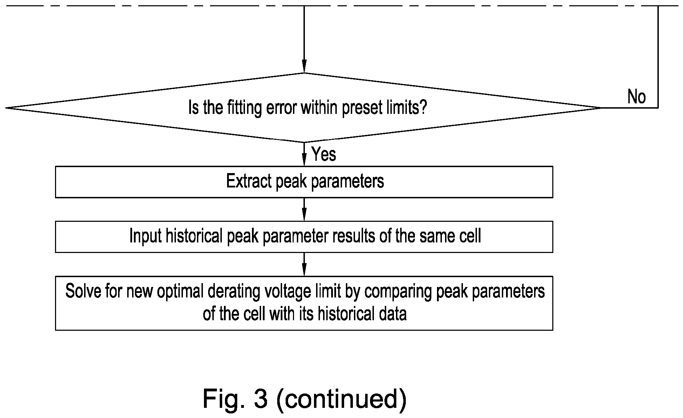

The system can be used to monitor the condition of the cells by following the method outlined in Figure 3, in which an estimated open circuit potential or open circuit voltage (OCP/OCV) is calculated and compared to either dT/dV (where V is voltage across the cell and T is temperature for the cell) or dHF/dV (where HF is measured heat flux across the cell). These quantities are calculated by calculating the ratios of dT/dt or dHV/dt to dT/dt (where "t" is time). In the following description, dT/dV is the parameter used for differential thermal voltammetry (DTV) while dHV/dV is the parameter used for differential heat flux voltammetry (DHFV).

A mode of operation is applied to the battery pack 20 with current profile which is at least partially known. As shown in Figure 3, at step s1 raw data showing the voltage and temperature response of the battery during the time period in which the current is applied is input to the battery management system 10. At step s2, this data is separated and filtered into appropriate variables/matrices for further analysis,

In the preferred embodiment illustrated in Figure 3, the current profile comprises intermittent rest phases. That is, a charge current is which has intermittent rest periods of no applied current. The voltage response during each of these rest phases can be fitted to estimate the OCV using a designated equation at steps s3 to s6. This is now described in greater detail.

Under charge/discharge, the measured cell potential is a combination of the OCV and its overpotential which is dependent on current and internal resistance. In a pack application such as in electric vehicles and grid level storage, current distribution between each cell will vary depending on pack architecture, interconnection resistance and state of health (SOH). In order to determine the SOH independent of cell current and resistance, it is required to analyse the DTV data with respect to its OCV.

The intermittent constant current charge technique consists of a constant current charging phase and a short rest phase both of which can easily be carried out by existing systems such as consumer electronics and electric vehicles etc. The rest phase is set to occur every few minutes (depending on charging current) where the rest phase itself lasts a few seconds. For example 5s of rest every 100s of 1C charging. The cell potential will approach its OCV following lithium ion diffusion however this process can take hours to reach saturation. According to the preferred embodiment, the first few seconds of potential profile at rest are taken. These are fit to a designated equation (such as a power equation or diffusion equation) at step s3 to extract the parameters of that equation at step s4. This can then be extrapolated to find OCV at given states of charge. The final OCV of the cell can then be estimated by extrapolating between the calculated points at step s6. This way the OCV can be estimated during "normal" charging and DTV/DHFV analysis can be carried out at the same time. The computation is simple enough to be handled without excessive burden on the battery management system 10.

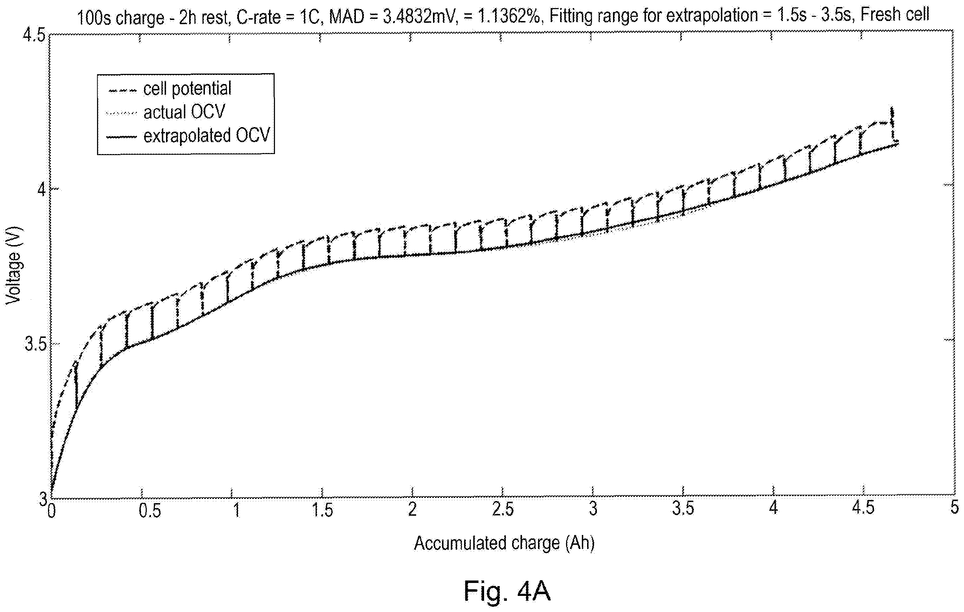

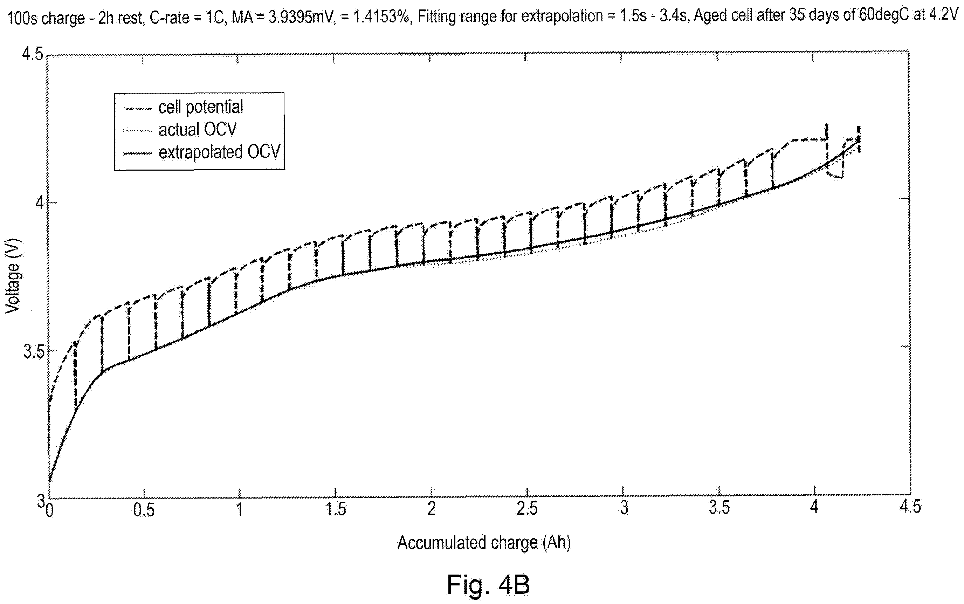

Figures 4A and 4B demonstrate the efficacy of this process to calculate OCV using a power equation for fresh and aged cells respectively. For the purpose of these figures, cells were charged with 2h rest every 100s charge at various C-rates. Assuming 2 hours is enough to reach saturation (i.e. OCV), the estimated OCV was extrapolated from initial few seconds of rest data and compared to the actual value after 2 hours.

Figure 4A relies on a power equation to reach the estimated OCV. In particular, a 2nd order power equation is a simplification of the exact representation of the diffusion process to minimise computation time and requirement. The equation was used to fit the rest profile. Figure 4A shows the estimated OCV (full line), the actual OCV (dotted line) and recorded cell potential (dashed line).

Figure 4B again shows OCV calculated using a power equation, this time for an aged cell. Figure 4B shows the estimated OCV (full line), the actual OCV (dotted line) and recorded cell potential (dashed line).

Using a diffusion equation may provide a closer-to-reality representation of the diffusion process. While making few assumptions to simplify the computation, the result is accurate enough for the purpose. The two main equations are Fick's second law of diffusion for spherical coordinates and the Nernst equation. The equations are combined to relate the cell potential with respect to time with several constants including the diffusion coefficient.

With the OCV estimated, the next stage is develop and understanding of DTV of DHFV. At steps s7 to s9, the raw temperature or heat flux data is smoothed. At step s7, smoothing parameters are defined. These are used to smooth data using a moving average method at step s8. A final check to ensure the smoothed profile and the raw data lie within pre-set limits is carried out at step s9. In particular, in preferred embodiments, the median of absolute deviation (MAD) is kept below a pre-set margin. For example, this may be 0.1% for temperature and 7.5% for heat flux. The skilled person will recognise that the appropriate technique and parameters can be highly dependent on the noisiness of the raw data i.e. quality of measurement equipment, data acquisition accuracy/precision etc.

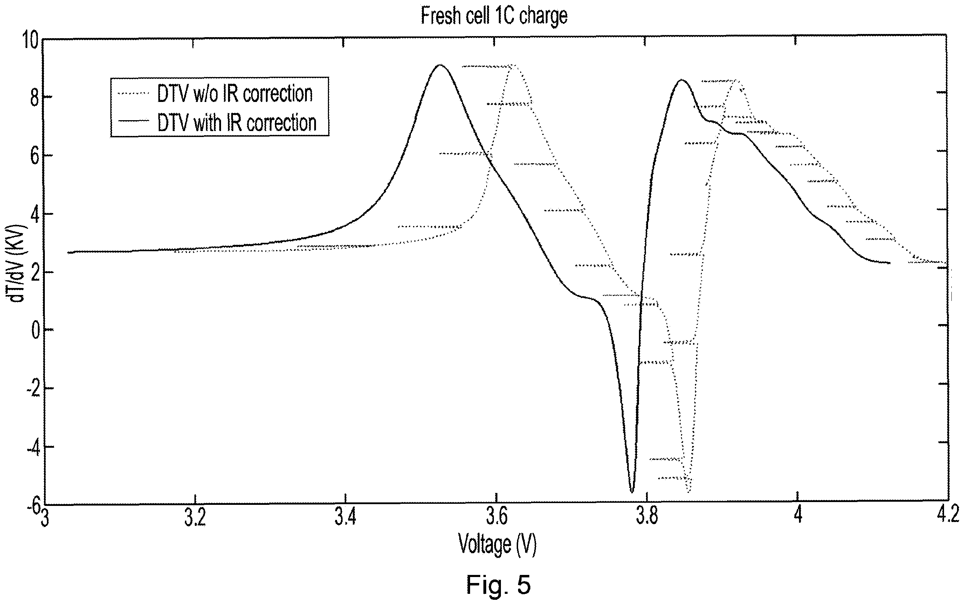

The data is then used to calculate for dT/dV and/or dHF/dV at step s10. These will give a relationship between these values and the OCV. Figure 5 illustrates such a relationship for an individual cell with a full line (the dotted line shows an example where no adjustment had been made to adjust for OCV).

Current battery applications use agnostic derating where the cells are limited to operate between a preselected fixed state-of-charge (SOC) range to minimise degradation accelerated at high and/or low voltage. This is clearly not effectively utilising the available power/energy in a cell. For example batteries in a Chevrolet Volt are limited between 30% and 80% SOC and Nissan LEAF model 2013 is limited up to 80%. For electric vehicle applications especially in sports where the vehicle needs to push to its extremes, a more intelligent derating system is critical.

Once the OCV profile is obtained the DTV parameter can be plotted against its OCV for peak analysis. This process is illustrated at steps s11 to s15. Firstly, at step s11, peak fitting parameters may be defined, and peaks may then be fitted to the DTV or DHFV profile with respect to OCV (step s12). A check may be made to ensure that the fitting error lies within preset limits at step s13 and peak parameters extracted at step s14. A comparison can then be made with historic peak parameters of that cell or others similar to it (step s15).

The evolution in peak parameters upon ageing will give quantitative information on the cell's SOH including temperature correction. At this stage, the OCV profile can also be decoupled into positive and negative electrode to give analysis on individual electrodes using existing OCV models.

The stoichiometric shift determined this way can be used to generate a revised optimum operating conditions for the cell, e.g. upper potential limit (step s16). This intelligent derating technique can maximise available power and energy while minimising accelerated degradation through cathode overcharge.

The ability of the disclosure to distinguish the condition of cells has been demonstrated in a series of experiments, as will be described further below. In these experiments, one deliberately aged cell and three fresh cells were placed together in the pack to determine whether the diagnosis methods could correctly determine the pack state-of-health. The aged cell was previously stored at 55degC at 4.2V for approximately 15 days. The pack was prepared in a way to minimise differences in external resistance such as equal cable lengths, fastening torque (8kN) and cleaned contact surfaces. Shunt resistors (RS 810-3273) were placed in series with each cell to measure the current distribution of the pack.

During the experiments, the pack was placed inside an incubator (Binder KB-23) with fan forced air convection flowing over the pack surface while keeping the incubator door open to emulate a surface cooling system to recreate conditions often found in real applications such as electric vehicles. Maccor Batter Tester series 4000 was used for measurements and loading during pack experiments whereas Bio-Logic BCS-815 was used for individual cell experiments. Pico TC-08 was used for heat flux sensor measurements and Yokogawa MX100 for shunt resistor measurements.

The pack experiment was carried out at 2C constant current charge and discharge where the pack was rested for at least 1 hour prior to each loading to ensure equilibrium state. For discharge, the pack was initially charged to 4.2V at 1C then held at 4.2V until current was less than 0.25A. For charge, the preparation was the same except it was to 2.7V. Then the cells were individually characterised through constant current discharges at 1/3C, 1C, 2C and 3C. The cells were initially charged at 1C to 4.2V then held until current was less than 0.1A.

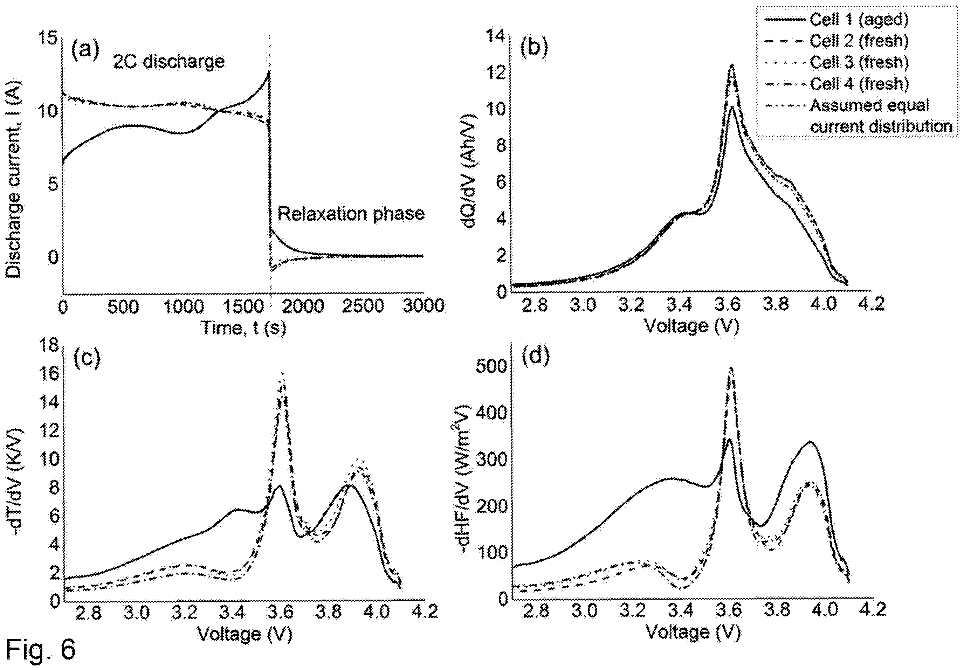

Figure 6 shows pack experimental results for 2C (40A) discharge. In particular figure 6 shows analysis under 2C constant current discharge; specifically Figure 6(a) shows cell current; Figure 6(b) shows an incremental capacity method; Figure 6(c) shows differential thermal voltammetry; and Figure 6(d) shows differential heat flux voltammetry.

In an ideal battery pack, each cell is expected to carry 10A. However, Figure 6(a) confirms that the current path between the four cells are heterogeneous. The three fresh cells have relatively similar current profile whereas the aged cell performs very differently. This is also reflected in the dQ/dV plot of Figure 6(b) as the different current profile results in different dQ term. This is due to the changes in thermodynamic overpotential and electrode stoichimetries for the aged cell. Thermodynamic overpotential is defined as the drop in potential due to internal resistances such as ohmic, ionic and charge transport. It is observed that the three fresh cells initially discharge at slightly higher than 10A to compensate for the low power performance of the aged cell. However, towards the end of its loading, the aged cell experiences higher current for the given pack voltage where it peaks at 2.86C (14.3A). Operating at higher current may promote degradation mechanisms such as lithium plating on charge and electrolyte decomposition by higher heat generation. This shows that having an unhealthy cell in a battery pack decreases its performance and accelerates pack aging reducing its operational lifetime. Hence it is crucial for a battery management system to be able to correctly identify unhealthy cells to be replaced at an early stage.

Figure 6(a) also shows internal current during relaxation. Cells were at different state-of-charges and therefore after removal of load and the imposed overpotentials, the current distributes amongst the cells. This further loads the cells and over time can get worse and lead to accelerated degradation.

Figures 6(c) and 6(d) show DTV and DHFV results respectively. The notable differences can be immediately observed between the one aged cell and the fresh cells.

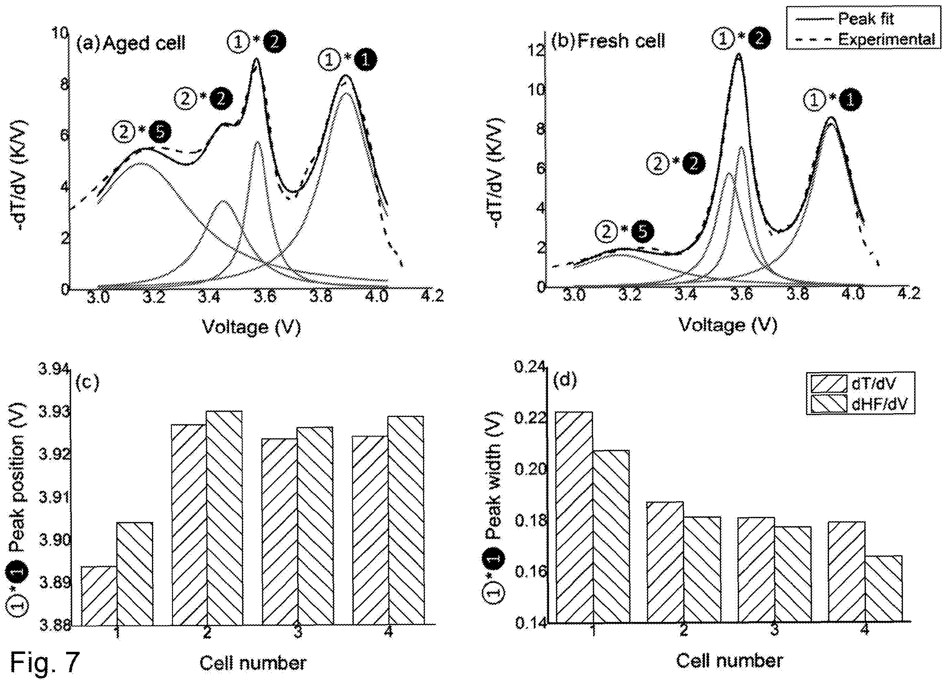

Figure 7 shows peak fitting of differential thermal and heat flux voltammetry results for 2C constant current discharge. Example peak fittings for cell 1 (Figure 7(a)) and cell 4 (Figure 7(b)). Figure 7(c) shows peak position (c) while Figure 7(d) shows peak width (d).

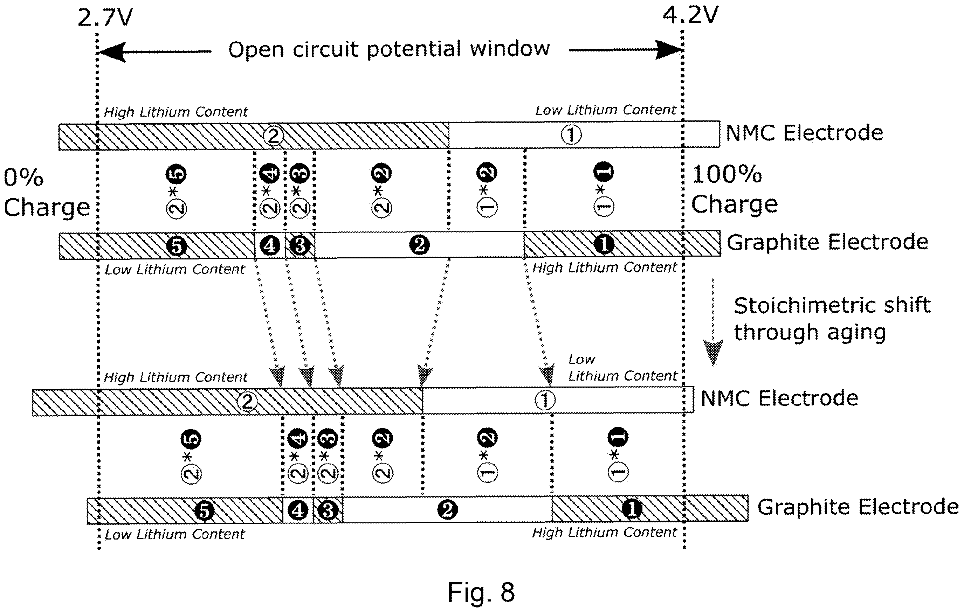

Each peak in these curves represents the combined phase of the positive and the negative electrode. Peak fitting analysis on the results were carried out using peakfit.m (https://terpconnectumd.edu/∼toh/spectrum/peakfit.m) script in MATLAB where the differences in the peak parameters such as the peak position and width can give information on the cell's state-of-health. Figures 7(a) and 7(b) demonstrate example peak fittings of DTV curves where each peak has been labelled accordingly for a combination of nickel-manganese-cobalt electrode lattice parameter evolution stage (①-②) and a graphitic carbon intercalation stage ( 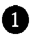 - 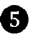 ). Figure 8 illustrates this concept of combined electrode phases.

It can be identified from the peak ①* 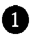 parameters as shown in Figures 7(c) and 7(d) that the aged cell has an evident lower peak position and a wider peak width than the fresh cells for both DTV and DHFV. Peak width is taken as the width of the peak at its half height. Degradation mechanisms such as electrolyte decomposition and metal dissolution will promote an increase in thermodynamic overpotential hence resulting in lower peak position at a given current. The increase of peak width can be explained from the initial lower current of the aged cell hence a slower discharge rate. Using this method, it is now possible to quantitatively diagnose the cell state-of-health and conclude that cell 1 has significantly aged compared to the remaining cells.

It can also be confirmed from this diagnosis that it is sufficient to analyse only peak ①* 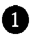 which is the first peak during discharge at approximately 3.9V. In Figure 7(a) and 7(b), it is observed that there is minimal overlap of the peaks above 3.8V. This suggests that DTV does not need to be carried out through the entire potential range of the cell which will further reduce the time of diagnosis i.e. it is sufficient to discharge from 4.2V to 3.8V to identify the aged cell.

In practice if the peak position of a particular cell is significantly shifted to a lower potential and/or the peak width is wider than the rest of the cells in a pack, it can be assumed that the cell is promoting unequal current distribution lowering the overall performance and the lifetime of the pack and should be replaced as soon as possible. Here the use of DTV and DHFV has been validated for identifying aged cells in a battery pack under a thermal management system. DHFV can be used when dT/dt is too small to measure due to strong cooling by the thermal management system.

In real application such as in electric vehicles, it may be more practical to be able to conduct the diagnosis under constant current charge. This would suggest that the diagnosis can be carried out whenever the electric vehicle is left to charge and no separate charging or discharging method is required.

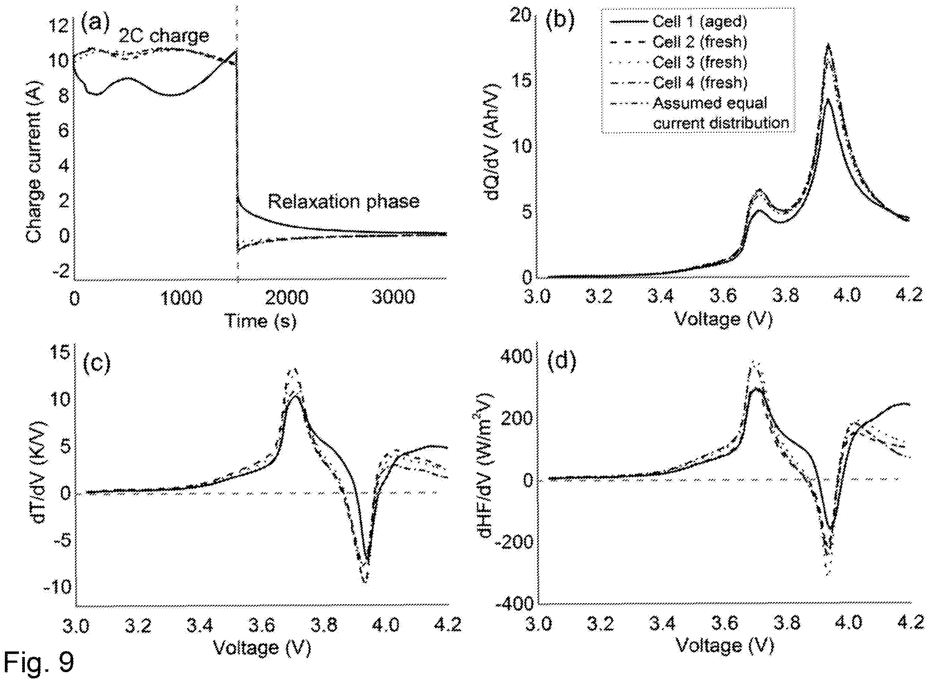

Figure 9 shows pack experiment results for 2C (40A) charge. In particular, Figure 9(a) shows cell current, Figure 9(b) shows results obtained using the incremental capacity method, Figure 9(c) shows results obtained using differential thermal voltammetry and Figure 9(d) shows results obtained using differential heat flux voltammetry. The aged cell can be identified for both DTV and DHFV. The negative peak here in Figure 9(c) and 9(d) appears from the negative dT/dt where the forced air cooling is stronger than the heat generated by the cell or potentially from the entropy terms.

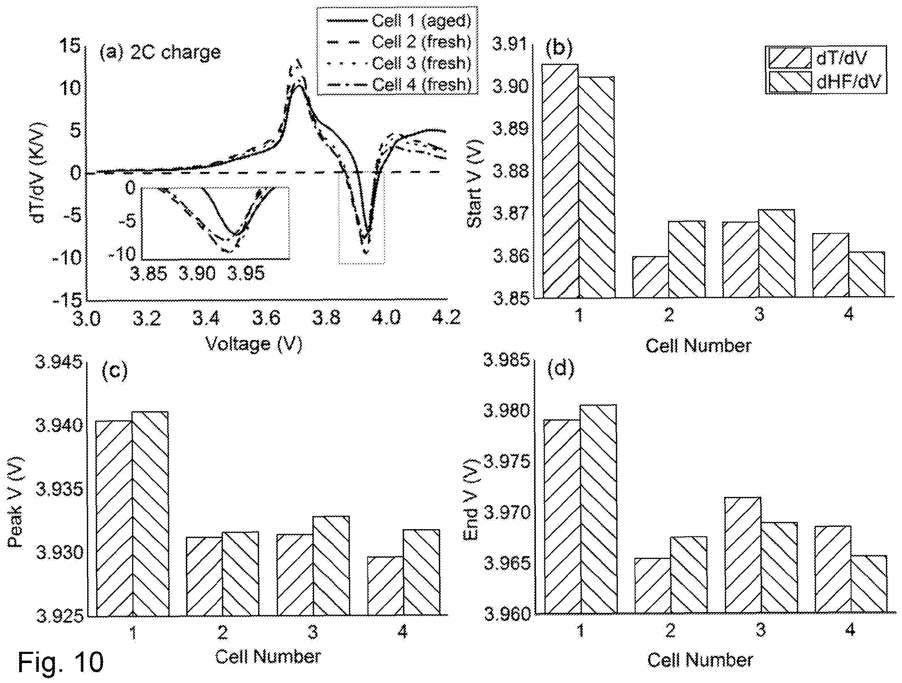

Figure 10 shows peak analysis of differential thermal and heat flux voltammetry results for 2C constant current charge. In particular, Figure 10(a) shows a zoomed in differential thermal voltammetry result, Figure 10(b) shows the potential at the x-axis intercept (i.e. dT/dV = 0) just before the negative peak, Figure 10(c) shows the potential for the negative peak and Figure 10(d) shows the potential at the x-axis intercept just after the negative peak.

Figure 10(a) shows the DTV result during 2C charge with a zoomed in figure on the negative peak. The negative peak here represents peak ①* 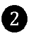 due to the negative dT/dt term. Figure 10(b), takes the potential at the initial x-axis intersect i.e. dT/dV = 0 and dHF/dV = 0. Figure 10(c) is the potential at the lowest point of the peak and Figure 9(d) shows the x-axis intersect after. It can be seen from all three parameters that the aged cell has a notably higher potential than the fresh cells for both DTV and DHFV which can be described by the stoichiometric drift of the electrodes. This method requires less computation as peak fitting is unnecessary. In practice, it may be recommend to use the potential at the initial x-axis intersect as the change is larger hence requires less resolution to measure the parameter on-board. Here the use of DTV and DHFV has been demonstrated for an on-board identification of aged cells in a battery pack under thermal management system during charge.

In order to validate the results above, the pack was then dismantled and characterisation tests were carried out on individual cells to validate the pack diagnosis results. The experimental setup was exactly the same but the cells were loaded individually. Constant current discharges at 1/3C, 1C, 2C and 3C were performed. Capacity results are described in Table 1. The difference in the results between the fresh and the aged cells indicate higher internal resistance and the stoichiometric shift of the aged cell which is translated into the DTV and DHFV pack analysis.

**Table 1**

| **Discharge capacity (Ah)** | | | | |
|---|---|---|---|---|
| | 1/3C | 1C | 2C | 3C |
| **Cell 1** | 4.65 | 4.53 | 4.39 | 4.38 |
| **Cell 2** | 5.05 | 4.97 | 4.83 | 4.84 |
| **Cell 3** | 5.06 | 4.97 | 4.83 | 4.84 |
| **Cell 4** | 5.05 | 4.97 | 4.82 | 4.82 |
| **Total** | 19.81 | 19.44 | 18.87 | 18.88 |

Variations and modifications will be apparent to the skilled person. Such variations and modifications may involve equivalent and other features which are already known and which may be used instead of, or in addition to, features described herein. Features that are described in the context of separate embodiments may be provided in combination in a single embodiment. Conversely, features which are described in the context of a single embodiment may also be provided separately or in any suitable sub-combination.

It should be noted that the term "comprising" does not exclude other elements or steps, the term "a" or "an" does not exclude a plurality, a single feature may fulfil the functions of several features recited in the claims and reference signs in the claims shall not be construed as limiting the scope of the claims. It should also be noted that the Figures are not necessarily to scale; emphasis instead generally being placed upon illustrating the principles of the present invention. Where ranges are disclosed, they should be considered to include their endpoints.

## Claims

1. A method of monitoring the condition of one or more cells within an electrochemical energy storage device, the method comprising:
operating the electrochemical device at a current comprising a predefined time-varying component for a first period of time;
sensing voltage across each of the plurality of cells during the first time period;
sensing a measure of heat generation within each cell during the first time period;
calculating an estimate of the open circuit potential of the electrochemical storage device from the predefined time varying component of the current and the sensed voltage during the first time period;
calculating, for each cell, a function which relates a ratio of the time derivatives of the sensed measure of heat generation and voltage to the open circuit potential; and
determining a measure of the state of health of each cell based on the calculated function.

2. A method according to claim 1, wherein the measure of heat generation is a temperature measurement or a heat flux measurement.

3. A method according to claim 1 or claim 2, wherein the step of operating the electrochemical device at a current comprises: charging the electrochemical device; discharging the electrochemical device; applying an intermittent current profile; or applying an oscillating current profile.

4. A method according to any one of the preceding claims, comprising, prior to calculating the ratio of time derivatives, smoothing values of the sensed measure of heat generation.

5. A method according to any one of the preceding claims, wherein the step of calculating an estimate of open circuit potential comprises fitting a rest profile of the sensed voltage to a power law model, or comprises applying a diffusion equation to the sensed voltage.

6. A method according to any one of the preceding claims, wherein the step of determining a measure of the state of health of each cell comprises analysing peaks within the calculated function.

7. A method according to any one of the preceding claims, further comprising calculating an operating range for each cell from the measure of the state of health for that cell.

8. A method according to claim 7, further comprising operating the electrochemical storage device such that each cell remains within its operating range.

9. A system for monitoring the condition of one or more cells within an electrochemical energy storage device, the system configured to:
operate the electrochemical device at a current comprising a predefined time-varying component for a first period of time;
sense voltage across each of the plurality of cells during the first time period;
sense a measure of heat generation within each cell during the first time period;
calculate an estimate of the open circuit potential of the electrochemical storage device from the predefined time varying component of the current and the sensed voltage during the first time period;
calculate, for each cell, a function which relates a ratio of the time derivatives of the sensed measure of heat generation and voltage to the open circuit potential; and
determine a measure of the state of health of each cell based on the calculated function.

10. A system according to claim 9, wherein the measure of heat generation is a temperature measurement or a heat flux measurement.

11. A system according to any one of claims 9 to 10, wherein the step of operating the electrochemical device at a current comprises charging the electrochemical device or discharging the electrochemical device.

12. A system according to any one of claims 9 to 11, wherein the system is configured to operate the electrochemical device at a current by applying an intermittent current profile, or by applying an oscillating current profile.

13. A system according to any one of claims 9 to 12, the system being further configured to, prior to calculating the ratio of time derivatives, smooth values of the sensed measure of heat generation.

14. A system according to any one of claims 9 to 13, wherein calculating an estimate of open circuit potential comprises fitting a rest profile of the sensed voltage to a power law model, or comprises applying a diffusion equation to the sensed voltage.

15. A system according to any one of claims 9 to 14, wherein determining a measure of the state of health of each cell comprises analysing peaks within the calculated function.

## Patentansprüche

1. Verfahren zum Überwachen des Zustands von einer oder mehrerer Zellen innerhalb einer elektrochemischen Energiespeichervorrichtung, wobei das Verfahren umfasst:
Betreiben der elektrochemischen Vorrichtung mit einem eine vordefinierte zeitveränderliche Komponente umfassenden Strom für eine erste Zeitdauer;
Erfassen der Spannung über jede der Mehrzahl von Zellen während der ersten Zeitdauer;
Erfassen eines Wärmeentwicklungsmaßes innerhalb jeder Zelle während der ersten Zeitdauer;
Berechnen einer Schätzung des Ruhepotenzials der elektrochemischen Vorrichtung aus der vordefinierten zeitveränderlichen Komponente des Stroms und der erfassten Spannung während der ersten Zeitdauer;
Berechnen einer Funktion, die ein Verhältnis der zeitlichen Ableitungen von erfasstem Wärmeentwicklungsmaß und Spannung zum Ruhepotential in Beziehung setzt, für jede Zelle; und
Bestimmen eines Gesundheitszustandsmaßes jeder Zelle basierend auf der berechneten Funktion.

2. Verfahren gemäß Anspruch 1, wobei das Wärmeentwicklungsmaß eine Temperaturmessung oder eine Wärmeflussmessung ist.

3. Verfahren gemäß Anspruch 1 oder Anspruch 2, wobei der Schritt des Betreibens der elektrochemischen Vorrichtung mit einem Strom umfasst: Laden der elektrochemischen Vorrichtung; Entladen der elektrochemischen Vorrichtung; Anwenden eines intermittierenden Stromverlaufs; oder Anwenden eines oszillierenden Stromverlaufs.

4. Verfahren gemäß einem der vorhergehenden Ansprüche, das vor dem Berechnen des Verhältnisses der zeitlichen Ableitungen ein Glätten der Werte des erfassten Wärmeentwicklungsmaßes umfasst.

5. Verfahren gemäß einem der vorhergehenden Ansprüche, wobei der Schritt des Berechnens einer Schätzung des Ruhepotenzials ein Fitten eines Ruheverlaufs der erfassten Spannung auf ein Potenzmodell umfasst, oder ein Anwenden einer Diffusionsgleichung auf die erfasste Spannung umfasst.

6. Verfahren gemäß einem der vorhergehenden Ansprüche, wobei der Schritt des Bestimmens eines Gesundheitszustandsmaßes jeder Zelle ein Analysieren von Peaks innerhalb der berechneten Funktion umfasst.

7. Verfahren gemäß einem der vorhergehenden Ansprüche, das ferner ein Berechnen eines Betriebsbereichs für jede Zelle aus dem Gesundheitszustandsmaß für diese Zelle umfasst.

8. Verfahren gemäß Anspruch 7, das ferner ein Betreiben der elektrochemischen Speichervorrichtung in einer Weise umfasst, so dass jede Zelle innerhalb ihres Betriebsbereichs bleibt.

9. System zum Überwachen des Zustands von einer oder mehreren Zellen innerhalb einer elektrochemischen Energiespeichervorrichtung, wobei das System ausgelegt ist zum:
Betreiben der elektrochemischen Vorrichtung mit einem eine vordefinierte zeitveränderliche Komponente aufweisenden Strom für eine erste Zeitdauer;
Erfassen der Spannung über jede der Mehrzahl von Zellen während der ersten Zeitdauer;
Erfassen eines Wärmeentwicklungsmaßes innerhalb jeder Zelle während der ersten Zeitdauer;
Berechnen einer Schätzung des Ruhepotenzials der elektrochemischen Vorrichtung aus der vordefinierten zeitveränderlichen Komponente des Stroms und der erfassten Spannung während der ersten Zeitdauer;
Berechnen einer Funktion, die ein Verhältnis der zeitlichen Ableitungen von erfasstem Wärmeentwicklungsmaß und Spannung zum Ruhepotential in Beziehung setzt, für jede Zelle; und
Bestimmen eines Gesundheitszustandsmaßes jeder Zelle basierend auf der berechneten Funktion.

10. System gemäß Anspruch 9, wobei das Wärmeentwicklungsmaß eine Temperaturmessung oder eine Wärmeflussmessung ist.

11. System gemäß einem der Ansprüche 9 bis 10, wobei der Schritt des Betreibens der elektrochemischen Vorrichtung mit einem Strom ein Laden der elektrochemischen Vorrichtung oder ein Entladen der elektrochemischen Vorrichtung umfasst.

12. System gemäß einem der Ansprüche 9 bis 11, wobei das System ausgelegt ist zum Betreiben der elektrochemischen Vorrichtung mit einem Strom durch Anwenden eines intermittierenden Stromverlaufs oder durch Anwenden eines oszillierenden Stromverlaufs.

13. System gemäß einem der Ansprüche 9 bis 12, wobei das System ferner ausgelegt ist, vor dem Berechnen des Verhältnisses der zeitlichen Ableitungen, Werte des erfassten Wärmeentwicklungsmaßes zu glätten.

14. System gemäß einem der Ansprüche 9 bis 13, wobei das Berechnen einer Schätzung des Ruhepotenzials ein Fitten eines Ruheverlaufs der erfassten Spannung auf ein Potenzmodell umfasst, oder ein Anwenden einer Diffusionsgleichung auf die erfasste Spannung umfasst.

15. System gemäß einem der Ansprüche 9 bis 14, wobei das Bestimmen eines Gesundheitszustandsmaßes jeder Zelle ein Analysieren von Peaks innerhalb der berechneten Funktion umfasst.

## Revendications

1. Procédé de surveillance de l'état d'une ou plusieurs cellules à l'intérieur d'un dispositif de stockage d'énergie électrochimique, le procédé comprenant :
le fonctionnement du dispositif électrochimique à un courant comprenant une composante variant dans le temps prédéfinie pendant un premier laps de temps ;
la détection de la tension aux bornes de chacune de la pluralité de cellules pendant le premier laps de temps ;
la détection d'une mesure de génération de chaleur à l'intérieur de chaque cellule pendant le premier laps de temps ;
le calcul d'une estimation du potentiel en circuit ouvert du dispositif de stockage électrochimique à partir de la composante variant dans le temps prédéfinie du courant et de la tension détectée pendant le premier laps de temps ;
le calcul, pour chaque cellule, d'une fonction qui associe un rapport des dérivées temporelles de la mesure de génération de chaleur et de la tension détectées au potentiel en circuit ouvert ; et
la détermination d'une mesure de l'état de santé de chaque cellule sur la base de la fonction calculée.

2. Procédé selon la revendication 1, dans lequel la mesure de génération de chaleur est une mesure de température ou une mesure de flux de chaleur.

3. Procédé selon la revendication 1 ou la revendication 2, dans lequel l'étape de fonctionnement du dispositif électrochimique à un courant comprend : la charge du dispositif électrochimique ; la décharge de dispositif électrochimique ; l'application d'un profil de courant intermittent ; ou l'application d'un profil de courant oscillant.

4. Procédé selon l'une quelconque des revendications précédentes comprenant, avant le calcul du rapport de dérivées temporelles, le lissage de valeurs de la mesure de génération de chaleur détectée.

5. Procédé selon l'une quelconque des revendications précédentes, dans lequel l'étape de calcul d'une estimation du potentiel en circuit ouvert comprend le lissage d'un profil au repos de la tension détectée par un modèle de loi de puissance, ou comprend l'application d'une équation de diffusion à la tension détectée.

6. Procédé selon l'une quelconque des revendications précédentes, dans lequel l'étape de détermination d'une mesure de l'état de santé de chaque cellule comprend l'analyse de pics à l'intérieur de la fonction calculée.

7. Procédé selon l'une quelconque des revendications précédentes, comprenant en outre le calcul d'une plage de fonctionnement pour chaque cellule à partir de la mesure de l'état de santé pour cette cellule.

8. Procédé selon la revendication 7, comprenant en outre le fonctionnement du dispositif de stockage électrochimique de telle sorte que chaque cellule reste à l'intérieur de sa plage de fonctionnement.

9. Système de surveillance de l'état d'une ou plusieurs cellules à l'intérieur d'un dispositif de stockage d'énergie électrochimique, le système étant configuré pour :
faire fonctionner le dispositif électrochimique à un courant comprenant une composante variant dans le temps prédéfinie pendant un premier laps de temps ;
détecter la tension aux bornes de chacune de la pluralité de cellules pendant le premier laps de temps ;
détecter une mesure de génération de chaleur à l'intérieur de chaque cellule pendant le premier laps de temps ;
calculer une estimation du potentiel en circuit ouvert du dispositif de stockage électrochimique à partir de la composante variant dans le temps prédéfinie du courant et de la tension détectée pendant le premier laps de temps ;
calculer, pour chaque cellule, une fonction qui associe un rapport des dérivées temporelles de la mesure de génération de chaleur et de la tension détectées au potentiel en circuit ouvert ; et
déterminer une mesure de l'état de santé de chaque cellule sur la base de la fonction calculée.

10. Système selon la revendication 9, la mesure de génération de chaleur étant une mesure de température ou une mesure de flux de chaleur.

11. Système selon l'une quelconque des revendications 9 à 10, l'étape de fonctionnement du dispositif électrochimique à un courant comprenant la charge du dispositif électrochimique ou la décharge du dispositif électrochimique.

12. Système selon l'une quelconque des revendications 9 à 11, le système étant configuré pour faire fonctionner le dispositif électrochimique à un courant en appliquant un profil de courant intermittent, ou en appliquant un profil de courant oscillant.

13. Système selon l'une quelconque des revendications 9 à 12, le système étant également configuré pour, avant de calculer le rapport de dérivées temporelles, lisser des valeurs de la mesure de génération de chaleur détectée.

14. Système selon l'une quelconque des revendications 9 à 13, le calcul d'une estimation du potentiel en circuit ouvert comprenant le lissage d'un profil au repos de la tension détectée par un modèle de loi de puissance, ou comprenant l'application d'une équation de diffusion à la tension détectée.

15. Système selon l'une quelconque des revendications 9 à 14, la détermination d'une mesure de l'état de santé de chaque cellule comprenant l'analyse de pics à l'intérieur de la fonction calculée.
